Europäisches Patentamt

(19) European Patent Office

Office européen des brevets

(11) Publication number: **0 147 901**
**B1**

## (12) EUROPEAN PATENT SPECIFICATION

(45) Date of publication of patent specification: **20.12.89**

(21) Application number: **84201901.0**

(22) Date of filing: **18.12.84**

(51) Int. Cl.⁴: **H 05 K 3/42, B 05 D 7/22**

(54) Method for coating with ink the walls of through holes in supports for electric circuits, and machine for implementing said method.

(30) Priority: **20.12.83 IT 2426683**

(43) Date of publication of application:
**10.07.85 Bulletin 85/28**

(45) Publication of the grant of the patent:
**20.12.89 Bulletin 89/51**

(84) Designated Contracting States:
**DE FR GB NL SE**

(56) References cited:
**DE-A-1 237 658**
**GB-A-2 030 007**
**GB-A-2 100 520**

**IBM TECHNICAL DISCLOSURE BULLETIN, vol.
16, no. 11, April 1974, page 3560, New York, US;
G.E. MELVIN: "Via hole metal paste deposition"**

(73) Proprietor: **ITALTEL SOCIETA ITALIANA
TELECOMUNICAZIONI s.p.a.
P.le Zavattari, 12
I-20149 Milano (IT)**

(72) Inventor: **Scorta, Roberto
Via L. Biraghi, 18
Milan (IT)**

(74) Representative: **Coggi, Giorgio et al
ITALTEL Società Italiana Telecomunicazioni
s.p.a. (Servizio Brevetti) Casella Postale 10
I-20019 Settimo Milanese (MI) (IT)**

Courier Press, Leamington Spa, England.

**Description**

The present invention concerns a method for coating with a conductive or insulating ink the walls of through holes in supports for electric circuits as, for example, holes in a substratum of alluminium or other material used as a support for thick film circuits which, as is well known, are made by placing a plurality of pastes or inks, with the caracteristics (conductivity, resistivity, insulation, etc.) required in each specific case, on a substratum by means of silk-screen processes and opportune stencils. After being deposited, each paste or ink requires a baking phase in order to eliminate the organic solvents and avoid being altered by any further layers that might be placed over it.

Furthermore, the invention also concerns a machine that implements the said method.

The growing complexity of circuits has made it necessary to start using two-faced or multi-layer thick film circuits; thus the problem of how to connect the two separate circuits on the two sides of the same substratum to each other, has arisen.

Several different solutions have been proposed amongst which:

1) use metallic U bolts to connect small blots made along the edges on the opposite sides of the substratum to each other: this solution imposes restraints on the topography of the two thick film circuits which can be extremely binding, and is certainly uneconomical unless there are very few connections to be made;

2) deposit ink in the holes by means of a silk-screen process and then suck it through the holes; during the following, indispensable baking operation, the ink filling the holes is reduced in volume. Then two things can happen: if it is detached from the edges of the holes the result is a connection which easily falls and is therefore unreliable; if it remains attached to the edges of the holes, breakage occurs casually in the central area, thus creating an irregular discontinuity which does not allow visual control of the continuity of the conductive layer on the walls of the hole itself. Furthermore, in the case of a multilayer circuit, the process is very delicate and necessitates frequent cleaning operations of the frame used for the silk-screen process;

3) force the ink under pressure once or more times through the holes in the support: the results thus obtained are without a doubt much better than those obtained or that may be obtained with the methods already described, but very often the holes are obstructed by the ink, so not allowing visual control of the caracteristics (thickness, uniformity etc) of the layer of ink that coats the through holes of the support.

The above coating method and a machine for implementing it are known, for example, from the Patent GB—A—2.100.520.

The method that forms the object of the present invention makes it possible to avoid the inconveniences of the process, without a doubt valid and advantageous, that has just been described, and includes the following phases:—

the support with the holes to be metalized is inserted and fixed between a first jig, fixed to the bottom of the machine used to implement said method, and a second jig; both jigs are made of semi-rigid or rigid material and have the same holes as the support;

the ink contained in a chamber with a variable volume is forced with pressure through the holes of the support and of the jigs;

when the machine operator observes that the ink has passed through the holes of the support (for example, when it comes out of the second jig), a depression is created in the chamber to suck back any excess ink.

Furthermore, in order to allow perfect opening of all the through holes, during the phase of sucking back all the excess ink, means are worked that are placed above the second jig and which progressively open all the holes in small groups. Using a conductive ink the method described in the invention makes perfect metallization of through holes possible; the same method, with insulating ink, makes it possible to insulate (if necessary) from the tracks present on either one or both sides of the substratum (or from the substratum itself it it is made of conductive material) the reophores of discreet components mounted onto the support itself, as well as to protect previously metalized holes with an insulating layer.

Further details of the method described in the invention will be indicated in the description of an example of realization of a semi-automatic machine designed to implement the method itself, and which is illustrated with the help of the attached figures, wherein:

Figure 1 shows a semplified cross section of the machine;

Figure 2 shows a partial cross section of the front view of the same machine;

Figure 3 shows a top view of the same machine and the plane A—A to which the section of Figure 1 corresponds;

Figure 4 shows an example of realization of the plate 21, of Figure 1, evidencing the form of the slots 22.

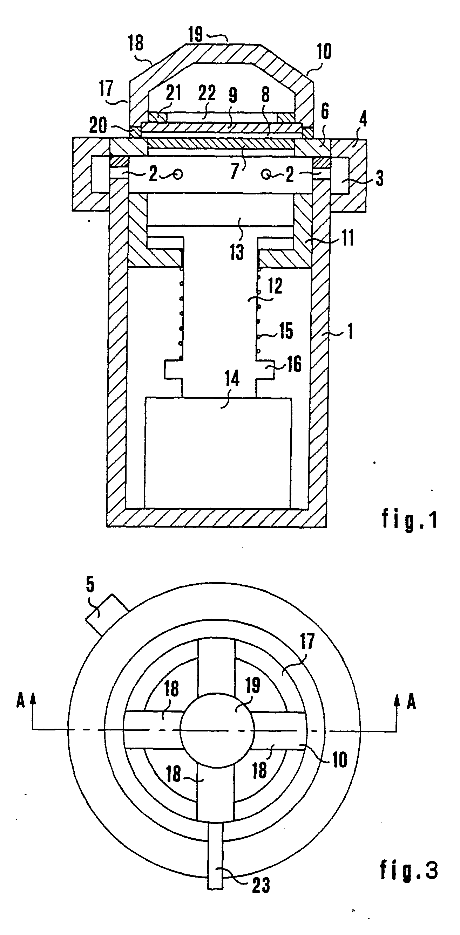

Figure 1 shows the cross section of an example of realization of a machine according to the invention; in the figures only the elements necessary to explain the operation of the machine have been briefly indicated. The proportions between the different parts are not necessarily true to reality.

The machine includes a cylindrical body 1 as its base, closed on the bottom and which has near its other extremity a ring of holes 2 placed at regular intervals and connected to each other by means of an annular cavity 3 made with a metallic body 4 applied with a water and air tight seal externally to body 1; it is possible, by means of the socket indicated by 5 in Figure 3 or another similar equivalent medium, to connect the annular cavity 3, and therefore by means of the holes 2, the inside of the cylindrical body 1, with means (for example a suction pump) not indicated in the figure and designed to create a depression in the cylindrical body.

It is possible, without leaving the ambit of the invention to connect the holes 2 directly to the suction means, without interpose the annular cavity 3. The body 1 is closed by a ring 6 to which a jig 7 with the same holes in it as the support is fixed in a non-permanent manner (for example by means of screws); the support 8, inserted between the first and a second jig (7, 9) is kept in place by the body 10, which will be illustrated in greater detail later on.

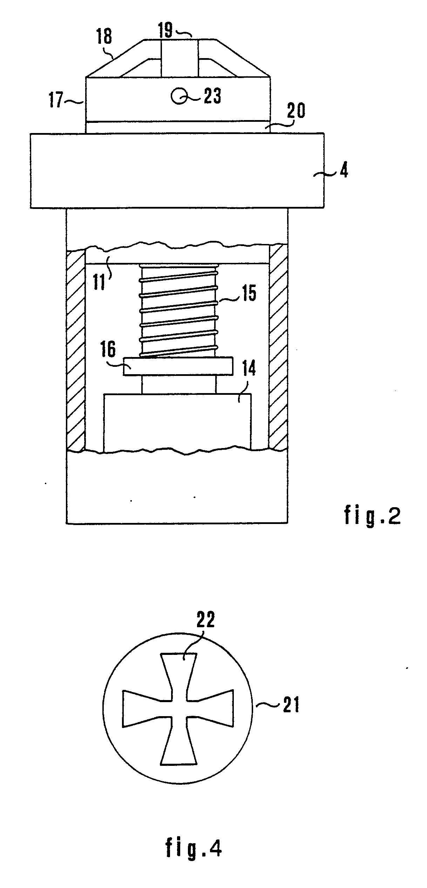

A cup-shaped metallic body 11, inside which there is placed a piston 12, is present in body 1: the ink is placed in the chamber 13 delimited by the cup 11 and the piston 12. The piston 12 is moved by hydraulic and/or pneumatic means generically represented in Figure 1 and 2 by the block 14, and it transmits movement to the cup 11 through the spring 15 wound around the leg of the piston 12 and which rests on the flange 16 which is integral to the leg itself. In order to metalize the through holes (non explicitely indicated in the figure) present in the support 8, the piston 12 is drawn up by the means 14; the cup 11, which in the beginning moves together with the piston 12 without changing the volume of the chamber 13, closes the holes 2 before stopping against the ring 6; the piston 12 varies on in its stroke compressing the spring 15 and forcing the ink contained in the chamber 13 to pass through the holes in the jigs (7, 9) and support 8.

The spring 15 makes the impact of the ink, pushed by the piston 12, against the complex jigs-piston (7, 8, 9) less harsh, thus reducing mechanical stress and making the pressure with which the ink passes through the holes more uniform; without leaving the ambit of the invention it is possible to substitute the spring 15 with other means (for example one or more shock absorbers) equivalent to it and with variable mechanical resistance.

Once the operator is certain that the ink has passed through all the holes in the support 8 (for example because he sees it come out of the jig 9), he inverts the flow of fluid in the means 14 thus allowing the piston to return back down; the spring 15, which is compressed, accelerates said return. Thus a depression is created in the chamber 13 which sucks the ink back into the chamber; the said action of sucking back is emphasized when the cup 11, going back down, uncovers the holes 2 which are connected, as was previously mentioned, to a suction pump or other equivalent means, designed to create a depression. The body 10 which blocks the support 8 and the jig 9 includes (in the preferred form of realization illustrated in the figure), an annular body 17 and four raised arms 18 that join together; the dimensions and shape of the arms 18 and body 17 allow the operator to be able to easily see the ink coming out of the jig 9.

The annular body 17 exercises a pressure on the jig 9, (which in a possible form of realization of the invention can be fixed to the body (17), which is due either to its own weight or to hydraulic and/or pneumatic means not explicitly indicated in the figure and which acts on the area 19 common to all four arms 18.

The ring 20, fixed preferably to the body 10, limits the mechanical stress induced by the body 10 on the jigs 7 and 9, and the support 8.

If the holes in the support 8 have a small diameter, the depression created in the chamber 13 will almost certainly open all the holes; if the holes have a larger diameter, a part of them may remain closed, especially if they are distant from the center of the support 8.

In order to avoid this inconvenience, the body 10 also includes a plate 21 which is positioned straight above the jig 9 and has one or more slots 22 which are sufficiently wide to allow the operator to see through the slots 22 and the spaces between the arms 18 when the ink comes out of the jig 9, but narrow enough to leave only a small part of the holes in the support 8 uncovered; thus the depression acts only on those holes that are uncovered each time, to open them.

By turning the plate 21, either by itself or together with the body 10, (for example using the lever indicated with 23 in Figures 2 and 3), the operator can uncover all the holes in the support one after the other, thus all the holes are opened.

Figure 4 shows an example of realization of the plate 21, which has two identical openings placed at right angles to one another and symmetrical about the central point which coincides with the spin axis of the plate, and which form a cross shaped opening that, if rotated 90° uncovers the whole surface of the support.

Without overstepping the limits of the invention it is possible for a technician to change the shape and/or the number of the openings 22 and the spin angle of the plate 21, and more in general, change one or more particulars of the machine described herein, such as for example, by realizing the first jig 7 on a mobile support which leans against the ring 6 (instead of being fixed to it as in Figure 1).

A method that includes the carrying out of two separate phases has been described: during the first phase the walls of the holes are covered with an ink by means of a double passage of the ink itself (through passage under pressure-suction back into the chamber 13), whilst during the second phase the holes are opened; furthermore, a semi-automatic machine that to implements said method has also been illustrated.

Experience has shown that a semi-automatic machine has a sufficiently high rate of production to satisfy the requirements of a medium-large department for the production of thick film circuits, considering the amount of time required to carry out all the other operations (silk-screen printing of the tracks, hybriding, etc.) involved in obtaining a thick film circuit; all the same we will briefly indicate the main problems to be solved in order to make the process of coating the walls of through holes with an ink completely automatic. The main problems involved are of two types:

loading of the support and unloading its at the end of the process; it does not appear easy to realize a sender capable of feeding the machine by picking up a support from a stock and positioning it with the necessary precision between the two jigs (the holes are very small and therefore a great amount of precision is required), and then again picking up the support at the end of the process and placing it, without damaging the still damp layer of ink, in the container ready for the following phase of oven baking;

determining the exact moment in which to reverse the movement of the piston (said moment depends upon a multiplicity of factors, such as for example the quantity of ink present in the chamber 13): if the movement is reversed too early one cannot be sure that the ink has penetrated into all the holes, if it is reversed too late part of the ink, (which is very expensive) cannot be sucked back into the chamber 13 and is therefore lost; furthermore, it is much easier that particles of ink, coming out the jig 7 when the cup 11 has once again uncovered the holes 2, are sucked into the holes 2 blocking them. Thus an automatic machine could include a plurality of stations:

one or more stations for loading and unloading of the supports;

a station for coating the walls with ink at which the piston has a stroke of a constant length, first forcing the ink to pass from the cavity 13 into a second cavity placed above the support-jig complex and subsequently sucking it back into the cavity 13;

a station at which the holes of the support are opened by means of a depression and preferably with the help of a plate 21.

An automatic machine of the type mentioned here, in order to operate correctly, requires a fairly complex logic; in order to control such a machine, a microprocessor of the type on sale nowadays, suitably programmed and interfaced with the opportune sensor and actuators, could be used to advantage.

**Claims**

1. Method for coating with ink the walls of through holes in supports for electric circuits, characterized in that it comprises the following steps in sequence one after the other:

the support (8) is inserted and fixed between a first jig (7), that constitutes one side of a chamber (13) with a variable volume, and a second jig (9) having the same holes as in the first one;

the ink contained in said chamber (13) is made to pass under pressure through the holes in the jigs (7, 9) and in the support (8);

once the ink has passed through all the holes in the support, a depression is created in the said chamber (13) which sucks the ink back again;

at the same time as said depression is created, means (21) positioned on the face of the jig- support complex (7, 8, 9) opposite the one facing the said chamber (13) are activated, so as to expose all the holes, one after the other or in small groups, to the action of the said sucking caused by said depression.

2. Machine designed to implement the method described in Claim 1, characterised in that it comprises:

a basic body (1) of a long shape and with a ring of holes (2) near one of its extremities that are positioned at regular intervals and are connected to external media for the creation of a depression;

first means (6) applied to the said extremity of the basic body and designed to carry a first jig (7);

second means (10) designed to fix the support (8) against the said first jig (7) and a second jig (9), having the same holes as in the first one (7); said second means (10) allowing observation of the second jig (9);

a hollow, cup-shaped metallic body (11), which slides within the basic body (1) and to which it is coaxial;

a piston (12) which is moved inside said cup-shaped body (11) by thrust means (14), the head of the said piston (12) delimiting, together wih the said cup-shaped body (11), a chamber (13) within a variable volume, designed to contain ink, so that when the thrust means (14) are activated, the metallic body (11) is drawn by the piston (12), closes the holes (2) in the basic body (1) and comes to a stop against the first means (6), whilst the piston (12), continuing its stroke, reduces the volume of the chamber (13) containing the ink;

said second means (10) also including an annular body (17) and a plate (21) placed inside said annular body (17) and in direct contact with the second jig (9) and having at least one opening (22).

3. Machine as described in Claim 2, characterized by the fact that the first means (6) include a metallic ring to which the first jig (7) is fixed in a non-permanent manner.

4. A machine as described in Claim 2 characterized by the fact that the second means (10) include said annular body (17) and four identical arms (18) which branch out at regular intervals from the annular body (17) and meet in a common area (19), said annular body (17) acting on the second jig (9).

5. A machine as described in Claim 4 characterized by the fact that the second jig (9) is attached in a non-permanent manner to the annular body (17).

6. A machine as described in Claim 2 characterized by the fact that it includes means with variable mechanical resistance that are positioned between the cup-shaped body (11) and the piston (12).

7. A machine as described in Claim 6 characterized by the fact that the means with variable mechanical resistance include a spring (15) wound around the leg of the piston (12) and positioned between the bottom of the cup-shaped body (11) and a flange (16) which is integral to the leg of the piston (12).

8. A machine as described in Claim 2 characterized by the fact that the said plate (21) has two identical openings (22) positioned at right angles to one another and symmetrical about their central point which coincides with the spin axis of the plate (21).

9. A machine as described in Claim 2 characterized by the fact that the said plate (21) is integral to the second means (10).

**Patentansprüche**

1. Methode zum Bestreichen mit Tinte der Durchgangslöcherwände in Haltern für elektrische Kreise, gekennzeichnet, von der Tatsache, dass sie die folgenden Schritte in der angegebenen Folge umfasst:

der Halter (8) ist zwischen einer ersten Maske (7), welche die Seite einer Kammer (13) mit veränderlichen Volumen darstellt, und einer zweiten Maske (9) mit denselben Löchern wie die erste;

die in der gesagten Kammer (13) enthaltene Tinte laeuft unter Druck durch die Loecher in die Masken (7, 9) und in den Halter (8)

sobald die Tinte durch alle Loecher im Halter durchgelaufen ist, wird ein Unterdruck in der gesagten Kammer (13) gebildet, der die Tinte zuruecksaugt;

gleichzeitig mit der Entstehung des o.g. Unterdruckes werden die Elemente (21), die sich an der Seite der Einheit Maske-Halter (7-8-9) der Wand der gesagten Kammer (15) gegenueber befinden auf eine Art bewegt, dass alle Loecher, das eine nach dem anderen oder in kleinen Gruppen, der Wirkung der gesagten Ansaugung ausgesetzt werden, die von dem genannten Unterdruck verursacht wird.

2. Maschine, die fuer die Durchfuehrung der Methode entsprechend dem Anspruch 1 geeignet ist, von der Tatsache gekennzeichnet, dass die folgende Teile umfasst:

den laenglichen Grundkoeper (1) mit einem Loecherring (2) an einem Ende; die Loecher befinden sind in regelmaesgen Abstaenden und sind mit aeusseren Mitteln fuer die Bildung eines Unterdruckes verbunden;

die ersten Mittel (6), die am oben genannten Ende des Grundkoerpers angebracht sind und dazu bestimmt sind, das erste Element (7) zu tragen;

die zweiten Mittel (10) zum Befestigen der Halter (8) gegen die erste und die zweite Masken (7 und 9), mit denselben Loechern wie in der ersten Maske (7); die gesagten zweiten Mittel (10) gestatten die Kontrolle an der zweiten Maske (9);

eine metallischen, hohlen, tassenfoermigen Koerper (11), der sich innerhalb des Grundkoepers (1) bewegt und mit diesem koaxial ist;

einen Kolben (12), der innerhalb des oben genannten tassenfoermigen Koerpers von Druckmitteln (14), die den Kopf des gesamten Kohlens (12) begrenzen, zusammen mit dem genannten tassenfoermigen Koerper (11) bewegt wird, eine Kammer (13) mit veraenderlichem Volumen, als Tintenbehaelter geeignet, sodass, wenn die Druckmittel (14) im Betrieb gesetzt werden, der metallische Koerper (11) vom Kolben (12) gezogen wird, die Loecher (2) in dem Grundkoerper (1) schliesst und einen Halt gegen die ersten Mittel (6) erreicht, waehrend der Kolben (12) beim Fortsetzen seines Hubes das Volumen der Kammer (13) herabsetzt, die die Tinte enthaelt;

die genannten zweiten Mittel (10) besitzen ferner einen Rinkoerper (17) und eine Platte (21) innerhalb des genannten Ringkoerpers (17) und in direkter Verbinung mit der zweiten Maske (9), mindestens mit einer Oeffnung (22).

3. Geraet, wie unter dem Anspruch 2 beschrieben, von der Tatsache gekennzeichnet, dass die ersten Mittel (6) einen metallischen Ring umfassen, an dem die erste Maske (7) durch eine nicht dauernde Verbindung befestigt ist.

4. Ein Geraet, wie unter dem Anspruch 2, beschreiben, von, der Tatsache gekennzeichnet, dass die zweiten Mittel (10) den oben erwaehten Ringkoerper (17) und vier identische Arme, die sich in regelmaessigen Abstaenden vom Ringkoerper trennen und in einem gemeinsamen Raum zusammentreffen (19), wobei der gesagte Ringkoerper (17) auf die zweite Maske (9) wirkt.

5. Ein Geraet, wie unter dem Anspruch 4 beschreiben, von der Tatsache gekennzeichnet, dass die zweite Maske (9) mit dem Ringkoerper (17) durch eine nicht dauernde Verbindung angeschlossen ist.

6. Ein Geraet, wie unter dem Anspruch 2, von der Tatsache gekennzeichnet, dass es Mittel mit einem veraenderlichen mechanischen Widerstand umfasst, die zwischen dem tassenfoermigen Koerper (11) und dem Kolben (12) positioniert sind.

7. Ein Geraet, wie unter dem Anspruch 6, beschrieben, von der Tatsache gekennzeichnet, dass die Mittel mit einem veraenderlichen mechanischen Widerstand eine um den Schaft des Kolbens (12) umgewickelte Feder (15) enthalten, die zwischen dem Boden des tassenfoermigen Koerpers (11) und einer Flansche (16) positioniert ist, die Bestandteil des Schaftes des Kolbens (12) ist.

8. Ein Geraet, wie unter dem Anspruch 2, beschrieben, von der Tatsache gekennzeichnet, dass die oben erwaehnte Platte (12) zwei identische Oeffnungen (22) aufweist, die sich im rechten Winkel miteinander und symmetrisch zu ihrem Kreuzpunkt befindet, der mit der Rotationsachse der Platte (21) uebereinstimmt.

9. Ein Geraet, wie unter dem Anspruch 2 beschrieben, von der Tatsache gekennzeichnet, dass die oben genannten Platte (21) Bestandteil der zweiten Mittel (10) ist.

**Revendications**

1. Méthode d'encrage des parois de trous de passage dans les supports de circuits électriques, caractérisée par les opérations, mentionnèes ci-dessous, effectuées en séquence l'une après l'autre:

le support (8) est introduit et fixé entre un premier patron (7) constituant une paroi d'une chambre (13) à volume variable, et un deuxième patron (9) pourvu de trous identiques à ceux du premier;

l'encre qui se trouve dans cette chambre (13) est poussé sous pression à travers les trous des patrons (7, 9) et du support (8);

lorque l'encre est passé à travers tous les trous du support, dans la chambre (13) on crée une dépression qui aspire l'encre en arrière;

au moment même de la création de la dépression, les moyens (21) placés sur le côté de l'ensemble patron-support (7, 8, 9) opposé à celui donnant sur ladite chambre (13) soit mis en fonction, afin que tous les trous soient exposés à l'action de l'aspiration produite par la dépression, l'un après l'autre ou par petits groupes.

2. Machine conçue pour outiller la méthode décrite à la revendication 1, caractérisée par les éléments mentionnées ci-dessous:

un corps de base (1) de forme longue, muni d'une couronne de trous (2) près d'une de ses extrémités, uniformément espacès et connectés aux moyens extérieurs pour la création de la dépression;

premiers moyens (6), appliqués à la susdite extrémité et conçus de façon à porter un premier patron (7);

seconds moyens (10), conçus pour fixer le support (8) contre le premier patron (7) et un deuxième patron (9) muni de trous identiques à ceux du premier (7);

lesdits seconds moyens (10) permettent d'observer le deuxième patron (9);

un corps métallique (11) creux, en forme de cuvette, glissant à l'intérieur du corps de base (1) et coaxial à celui-ci;

un piston (12) déplacé à l'intérieur dudit corps en forme de cuvette (11) par des moyens de poussèe (14); la tête de ce piston (12), conjointement avec ledit corps en forme de cuvette (11), délimité une chambre (13) à volume variable conçue pour contenir l'encre, de façon que lorsque les moyens de poussée (14) sont mis en fonction le corps métallique (11) est entrâiné par le piston (12), bouche les trous (2) dans le corps de base (1) et s'arrête contre les premiers moyens (6), tandis que le piston (12), qui continue sa course, réduit le volume de la chambre (13) contenant l'encre;

lesdits seconds moyens (10) comprennent aussi un corps annulaire (17) et une plaque (21) placée à l'intérieur du corps annulaire (17) et directement en contact avec le deuxième patron (9) et pourvue d'au moins une fente (22).

3. Machine comme il est décrit à la revendication 2, caractérisée par le fait que les premiers moyens (6) comprennent une bague métallique à laquelle le premier patron (7) est fixé de façon non permanente.

4. Une machine comme il est décrit à la revendication 2, caractérisée par le fait que les seconds moyens (10) comprennent le corps annulaire (17) susdit et quatre bras identiques (18) qui s'éloignent du corps annulaire (17) à intervalles réguliers et se rencontrent dans une zone commune (19), ce corps annulaire (17) agissant sur le deuxième patron (9).

5. Une machine comme il est décrit à la revendication 4, caractérisée par le fait que le deuxième patron (9) est fixé au corps annulaire (17) de façon non permanente.

6. Une machine comme il est décrit à la revendication 2, caractérisée par le fait que la même comprend des moyens à résistance mécanique variable, placés entre le corps en forme de cuvette (11) et le piston (12).

7. Une machine comme il est décrit à la revendication 6, caractérisée par le fait que les moyens à résistance mécanique variable comprennent un ressort (15) enroulé autour de la tige du piston (12) et placé entre le fond du corps en forme de cuvette (11) et une bride (16) solidaire de la tige du piston (12).

8. Une machine comme il est décrit à la revendication 2, caractérisée par le fait que la plaque (21) susdite est munie de deux fentes identiques (22), l'une formant angle droit avec l'autre et symétriques par rapport à leur point médian, qui coïncide avec l'axe de rotation de la plaque (21).

9. Une machine comme il est décrit à la revendication 2, caractérisée par le fait que ladite plaque (21) est solidaire des seconds moyens (10).

fig.1

fig.3

1

fig.2

fig.4